# EUROPEAN PATENT APPLICATION

(11) **EP 4 576 213 A1**
(43) Date of publication of application: **25.06.2025**
(21) Application number: 23219257.5
(22) Date of filing: 21.12.2023
(51) Int. Cl.: H01L 25/075, H01L 33/58, H01L 33/62, H01L 33/52, H01L 25/16

(54) **DISPLAY APPARATUS**

(71) Applicant: LG Display Co., Ltd., Seoul 07336 (KR)
(72) Inventor: LEE, Dongseok, 10845 Paju-si (KR); RHIM, Jusang, 10845 Paju-si (KR); YOON, Sunghwan, 10845 Paju-si (KR); KANG, Minjae, 10845 Paju-si (KR); SHIN, Yuseop, 10845 Paju-si (KR); LEE, Rokhee, 10845 Paju-si (KR)
(74) Representative: Morrall, Jonathan Ian McLachlan

(57) **Abstract**

There is disclosed a display apparatus including a substrate (110), a first electrode (131) and a second electrode (132) that are disposed on the substrate (110), a bank layer (135) disposed on the first electrode and the second electrode, the bank layer comprising an opening (OP), a micro light emitting diode (ED1) disposed inside the opening of the bank layer (135), a high refractive index layer (LS or lens) disposed on the micro light emitting diode, an overcoat layer (151) disposed on the high refractive index layer (LS) and having a lower refractive index than the high refractive index layer, and a fixation member (143) disposed between the high refractive index layer and the bank layer (135).

## Description

### BACKGROUND

### [Technical Field]

The present disclosure relates to a display apparatus, more particularly, a display apparatus that may simplify a manufacturing process, and a manufacturing method of the same.

### [Description of the Related Art]

In flat panel displays, it is common to use a liquid crystal display apparatus (LCD) or an organic light emitting display apparatus (OLED).

The organic light emitting display apparatus has advantages of improved light emitting efficiency, rapid response speed, wide viewing angle, etc, compared with the liquid crystal display apparatus. However, the organic light emitting display apparatus still has low light emitting efficiency and contains organic materials, so it is vulnerable to foreign matter such as moisture. Accordingly, reliability and lifespan of organic light emitting display devices might be deteriorated.

Recently, a micro light emitting diode display apparatus, which is an inorganic light emitting display apparatus, has been proposed.

The micro light emitting diode display apparatus may realize an image by arranging an inorganic light emitting diode having size of approximately 100 micrometers (µm) or less in each pixel. In the micro light emitting diode, a process of transferring micro light emitting diodes grown on a single crystal substrate to an array substrate of the display apparatus using a stamp or the like is performed.

The description provided in the background section should not be assumed to be prior art merely because it is mentioned in or associated with the background section. The background section may include information that describes one or more aspects of the subject technology.

### BRIEF SUMMARY

In order to improve light extraction efficiency and adjust a viewing angle of a display apparatus. In some embodiments, a geometric pattern such as a lens is disposed on a micro light emitting diode.

In some solutions, after a process of transferring the micro light emitting diode and a process of connecting electrodes are performed, a lens is formed by applying a material for forming a lens and performing an exposure process. Inventors recognized that due to the performing of the exposure process for forming the lens, there is a disadvantage in that a manufacturing process of the display apparatus could be complicated together with increased manufacturing cost.

The inventors of the present disclosure invented a manufacturing method of a display apparatus that may simultaneously transfer a micro light emitting diode and a lens.

The present disclosure according to an embodiment provides a display apparatus that may simplify a manufacturing process thereof, and a manufacturing method of the same.

Aspects and technical features according to the present disclosure are not limited to the above ones, and other aspects and features that are not mentioned above can be clearly understood from the following description and can be more clearly understood from the embodiments set forth herein by people skilled in the art.

A display apparatus according to embodiments of the present disclosure may include a substrate: a planarization layer disposed on the substrate: a first electrode and a second electrode that are disposed on the planarization layer; an insulating layer disposed on the first electrode and the second electrode, the insulating layer comprising an opening: a micro light emitting diode disposed inside the opening of the insulating layer; a lens disposed on the micro light emitting diode; and an adhesive layer disposed between the lens and the insulating layer.

A manufacturing method of a display apparatus according to embodiments of the present disclosure may include forming a stamp having concave portions; forming lenses in the concave portions; primarily transferring micro light emitting diodes to the lenses; preparing an array substrate on which an adhesive layer is coated on each sub-pixel; and secondarily transferring the lenses and the micro light emitting diodes together to the array substrate.

Detailed descriptions of other embodiments are included in the following description and the accompanying drawings.

Additional features and aspects will be set forth in part in the following description and in part will become apparent from the following description, or may be learned by practice of the inventive concepts provided herein. Other features and aspects of the inventive concepts may be realized and attained by the structure particularly pointed out, or derivable therefrom, in the written description, the claims hereof, and the appended drawings

According to the embodiments of the present disclosure, the lens and the micro light emitting diode may be simultaneously mounted to the array panel by one transfer process. Accordingly, unlike the conventional manufacturing process that forms the lens by performing the photolithography process after the process of coating the material for forming the lens, the photolithography process may be eliminated in the present disclosure, thereby simplifying the manufacturing method of the display apparatus and reducing the manufacturing cost.

Since the lens having the curved upper surface is disposed in each micro light emitting diode, light extraction efficiency of the micro light emitting diode may be improved. Accordingly, the display apparatus may be operated with low power.

In addition to the above-described effects, specific effects of the present disclosure will be described together with the following detailed description for implementing the present disclosure.

### [BRIEF DESCRIPTION OF THE SEVERAL VIEWS OF THE DRAWINGS]

FIG. 1 is a plane view showing a display apparatus according to an exemplary embodiment of the present disclosure;
FIG. 2 is a cross-sectional view cut along 2-2 of FIG. 1;
FIG. 3 is a plane view showing a display apparatus according to another exemplary embodiment of the present disclosure;
FIG. 4 is a cross-sectional view cut along 4-4 of FIG. 3;
FIG. 5 is a plane view showing a display apparatus according to a further exemplary embodiment of the present disclosure;
FIG. 6 is a cross-sectional view cut along 6-6 of FIG. 5;
FIGS. 7a to 7f are views describing a manufacturing method of a display apparatus according to an exemplary embodiment of the present disclosure; and
FIGS. 8a to 8c are views describing a manufacturing method of a display apparatus according to an exemplary embodiment of the present disclosure.

### [DETAILED DESCRIPTION]

The technical benefits, features, advantages and methods to achieve them will be described later in detail with reference to the accompanying drawings, and accordingly, those skilled in the art to which the present disclosure belongs will be able to easily implement the technical idea of the present disclosure. In describing the present disclosure, if it is determined that the detailed description of the known technology related to the present disclosure may unnecessarily obscure the subject matter of the present disclosure, the detailed description will be omitted.

Hereinafter, example embodiments according to the present disclosure will be described in detail with reference to the accompanying drawings. In the drawings, the same reference numerals are used to indicate the same or similar components. The present disclosure should be construed to extend to any alterations, equivalents and substitutes in addition to those which are particularly set out in the accompanying drawings. Terms of respective elements used in the following description are terms defined taking into consideration the functions obtained in the present disclosure. Therefore, these terms do not limit technical elements in the present disclosure. Further, the defined terms of the respective elements may be referred to as other terms in the art. A singular representation may include a plural representation unless it represents a definitely different meaning from the context. Terms such as "include", "comprise", "contain", "consist of" or "has" are used herein and should be understood that they are intended to indicate an existence of several components, functions or steps, disclosed in the specification, and it is also understood that more or fewer components, functions, or steps may likewise be utilized.

In understanding the components, the components should be understood as including an appropriate error range even if there is no separate explicit description of such an error range.

It will be understood that when an element is referred to as being "connected with" or "adhered to" another element, the element can be directly connected with or adhered to the other element or intervening elements may also be present. In contrast, when an element is referred to as being "directly connected with" another element, there are no intervening elements present.

In descriptions of temporal relationships, for example, temporal precedent relationships between two events such as "after," "subsequent to," "next," "before," etc., another event may occur therebetween unless a more limiting term, such as "just," "immediate(ly)," or "direct(ly)" is used.

It will be understood that although the terms first, second, etc., may be used herein to describe various elements, these elements should not be limited by these terms. These terms are generally only used to distinguish one element from another.

Features of various embodiments may be partially or entirely combined with each other, and various connections and driving are possible. Also, embodiments may be implemented independently or implemented in a related relationship.

Hereinafter, a display apparatus according to embodiments of the present disclosure will be described referring to the accompanying drawings.

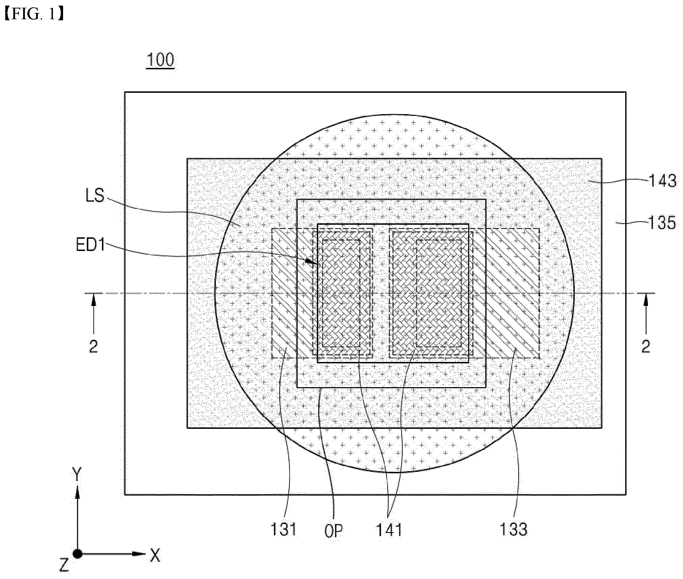

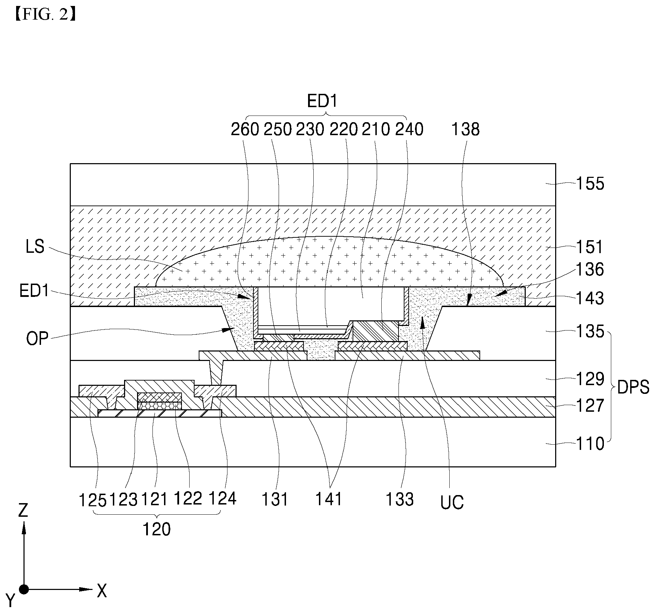

FIG. 1 is a plane view showing a display apparatus according to an embodiment of the present disclosure. FIG. 2 is a cross-sectional view cut away along 2-2 of FIG. 1. FIGS. 1 and 2 show an area corresponding to one sub-pixel of a display apparatus 100.

Referring to FIGS. 1 and 2, a display apparatus 100 according to an embodiment may include an array panel DPS; a micro light emitting diode ED1 mounted on the array panel DPS; and a lens LS disposed on the micro light emitting diode ED1.

The array panel DPS may include a substrate 110, a thin film transistor 120 disposed on the substrate 110; a first planarization layer 129 covering the thin film transistor 120; a first electrode 131 and a second electrode 133 which are disposed on the first planarization layer 129; and an insulating layer 135 having an opening OP.

The substrate 110 may be made of glass or plastic. For example, as the plastic substrate, polyimide (PI), polyethylene terephthalate (PET), acrylonitrile-butadiene-styrene copolymer(ABS), polymethyl methacrylate(PMMA), polyethylene naphthalate (PEN), polycarbonate (PC), polyethersulfone (PES), polyarylate (PAR), polysulfone (PSF), or ciclic-olefin copolymer , cyclic olefin copolymer(COC), triacetylcellulose(TAC) film, polyvinyl alcohol(PVA) film, and polystyrene(PS) may be used, but is not limited thereto.

The thin film transistor 120 may include a semiconductor layer 121 formed on the substrate 110; a gate insulating layer 122 and a gate electrode 123 which are disposed on the semiconductor layer 121; and a drain (or source) electrode 124 and a source (or drain) electrode 125.

The gate electrode 123 may be a single layer or multilayer made of Cr, Mo, Ni, Ta, Cu, Ti, Al or the like, or an alloy thereof, or may be a conductive compounds like metal nitride or other conductive material like doped polycrystalline silicon.. The gate insulating layer 122 may be a single layer or multilayer made of an inorganic insulating material such as silicon oxide, silicon nitride or silicon oxynitride. The semiconductor layer 121 may be made of a silicon semiconductor such as amorphous silicon or polycrystalline silicon, or it may be made of a metal oxide such as zinc (Zn), indium (In), gallium (Ga), tin (Sn), and titanium (Ti) or a combination of a metal such as zinc (Zn), indium (In), gallium (Ga), tin (Sn), or titanium (Ti) and its oxide. Specifically, the oxide semiconductor may include zinc oxide (ZnO), zinc-tin oxide (ZTO), zinc-indium oxide (ZIO), indium oxide (InO), titanium oxide (TiO), indium-gallium-zinc oxide (IGZO), indium-zinc-tin oxide (IZTO) , indium zinc oxide (IZO), indium gallium tin oxide (IGTO), and indium gallium oxide (IGO), but is not limited thereto. The drain electrode 124 and the source electrode 125 may be a single layer or multi layer made of metal such as Au, W, Pt, Si, Ir, Ag, Cu, Ni, Cr, Mo, Ta, Cu, Ti, Al or the like, or an alloy thereof or other conductive materials.

The thin film transistor is not limited to the structure shown in FIG. 2 but various structures may be applied to the thin film transistor. For example, the thin film transistor may also have a bottom gate structure.

The thin film transistor may be referred to herein by any of the following terms: a driving portion, a driving driver, and a driving chip.

Further, a thin film transistor according to the present disclosure may drive a single micro light emitting diode (ED1), but is not limited to, and may drive a plurality of micro light emitting diodes (ED1).

The drain electrode 124 and the source electrode 125 may be connected to the semiconductor layer 121 through (e.g., holes in) an interlayer insulating layer 127 covering the gate electrode 123 and the semiconductor layer 121, respectively. The interlayer insulating layer 127 may be composed of a single layer or multi layer made of an inorganic insulating material such as silicon oxide, silicon nitride or silicon oxynitride.

The first planarization layer 129 may be disposed on the thin film transistor 120 and the interlayer insulating layer 127. The first planarization layer 129 may be made of an organic insulating material such as acrylic resin, epoxy resin, phenolic resin, polyamides resin, unsaturated polyesters resin, polyphenylene resin, polyphenylene sulfides resin, and benzocyclobutene, polyacrylate, polyimide and the like, but embodiments are not limited thereto.

A first electrode 131 may be disposed on the first planarization layer 129 and the first electrode 131 may be connected to the drain (or source) electrode 124 of the thin film transistor 120 through (e.g., a hole in) the first planarization layer 129, directly or through an interconnection structure like a connection via coupled to the first electrode 131. A second electrode 133 spaced apart from the first electrode 131 may be disposed on the first planarization layer 129. The second electrode 133 may be connected to a low potential wire or a ground wire (not specifically shown for simplicity).

The first electrode 131 and the second electrode 133 may be a single layer or multi layer made of metal such as Au, W, Pt, Si, Ir, Ag, Cu, Ni, Cr, Mo, Ta, Cu, Ti, Al or the like, or an alloy thereof.

The insulating layer 135 having an opening OP for exposing a portion of the first electrode 131 and a portion of the second electrode 133 may be disposed on the first planarization layer 129. The insulating layer 135 may be made of a photosensitive organic material such as photoacryl or an inorganic material such as silicon oxide, silicon nitride, silicon oxynitride, etc.

In this disclosure, the insulating layer 135 may also be referred to as a bank layer.

Thus, the insulating layer 135 may be a pixel-defining layer or a subpixel-defining layer that defines a plurality of pixels or subpixels.

Further, the bank layer may be a black bank layer. This reduces unwanted light leakage and reflections.

A conductive adhesive layer 141 may be disposed on the first electrode 131 and the second electrode 133. The conductive adhesive layer 141 may be, for example, an anisotropic conductive film or solder.

The micro light emitting diode ED1 may be disposed inside the opening OP of the insulating layer 135. The micro light emitting diode ED1 may be disposed on the first electrode 131 and the second electrode 133. The micro light emitting diode DE1 may be manufactured by a separate manufacturing process and then transferred on the substrate 110.

The micro light emitting diode ED1 may be mounted in a flip-chip arrangement on the first electrode 131 and the second electrode 133 by the conductive adhesive layer 141.

For example, the micro light emitting diode ED1 may have a size of about 10 to 100 µm (e.g., 50µm) but the embodiment is not limited thereto. The micro light emitting diode ED1 may be formed using a group III-V compound semiconductor such as GaP, GaAs, GaSb, InP, InAs and/or InSb, or a group II-VI compound semiconductor such as CdS, CdSe, CdTe, ZnS, ZnSe, ZnTe, HgS, HgTe, and/or a combination thereof, but the embodiment is not limited thereto.

The micro light emitting diode ED1 may include a n-type semiconductor layer 210; an active layer 220 with a single quantum well SQW structure or a multi-quantum well MQW structure; a p-type semiconductor layer 230 disposed on the active layer 220; a p-side electrode 250 disposed on the p-type semiconductor layer 230; and an n-side electrode 240 that contacts the n-type semiconductor layer 210 in a partially removed area of the p-type semiconductor layer 230. In addition, the micro light emitting diode ED1 may include passivation layer 260 covering side surfaces and lower/upper surface of the p-type semiconductor layer 230. It is noted that in this paragraph, when a feature is described as being 'on' a feature in ED1, 'on' refers to being under rather than on top of due to the flip-chip arrangement as would be understood.

The n-type semiconductor layer 210 may be a layer for supplying an electron to the active layer 220. For example, the n-type semiconductor layer 210 may be formed by doping n-type impurity such as arsenic (As), phosphorus (P), antimony (Sb), germanium (Ge), tin (Sn), silicon (Si) on GaN.

The active layer 220 may be a layer on which an electron and a hole are coupled to generate light. For example, the active layer 220 may include at least one well layer made of InGaN and at least one barrier layer made of GaN, but the embodiment is not limited thereto.

The p-type semiconductor layer 230 may be a layer for injecting a hole to the active layer 220. For example, the p-type semiconductor 230 may be formed by doping p-type impurity such as indium (In), aluminum (Al), boron (B), gallium (Ga), Mg, Zn and Be on GaN.

The p-side electrode 250 and the n-side electrode 240 may be composed of a single layer or multi layer made of at least one metal of W, Si, Ir, Ag, C, Ni, Au, Pt, Ti, Al and Cr or an alloy thereof. An ohmic contact layer may be further disposed between the p-side electrode 250 and the p-type semiconductor layer 230. The ohmic contact layer may be made of a transparent metal oxide such as ITO(Indium Tin Oxide), IGZO(Indium Galium Zinc Oxide), and IZO(Indium Zinc Oxide)

The lens LS may be directly disposed on the micro light emitting diode ED1. The lens LS may have a larger area than the micro light emitting diode ED1 to fully cover the micro light emitting diode ED1. An upper surface of the lens LS may be convex. The lens LS may be made of a transparent organic material. For example, the lens LS may be made of acryl-based resin or a poly(3,4-ethylenediox-ythiophene), PEDOT. The lens LS may be disposed in one sub-pixel and a separate lens LS may be disposed for each micro light emitting diode ED1.

In this embodiment, a lower surface of the lens LS may be directly attached to the micro light emitting diode ED1 by its adhesive properties. The micro light emitting diode ED1 and the lens LS may be simultaneously mounted on the array panel DPS by one transfer process.

Accordingly, unlike the conventional manufacturing process that forms the lens by performing the photolithography process after the process of coating the material for forming the lens, the photolithography process may be eliminated in the present disclosure, thereby simplifying the manufacturing method of the display apparatus 100 and reducing the manufacturing cost.

The adhesive layer 143 may be disposed between the lens LS and the insulating layer 135. The adhesive layer 143 may be also disposed inside the opening OP of the insulating layer 135 to surround the side surfaces of the micro light emitting diode ED1. In some implementations, the lens LS includes a dimension in the x-axis and/or in the y-axis that is greater than a dimension of the micro light emitting diode EDI in the x-axis and/or in the y-axis such that an undercut area UC is formed. The undercut area UC enables the adhesive layer 143 to be directly disposed between the lens LS and the insulation layer 135, which further secures the lens LS and the micro light emitting diode ED1 to the DPS. Further, the micro emitting diode EDI extends in the z-axis beyond the insulting layer 135 such that there is a space 136 between the lens and an upper surface 138 of the insulating layer 135. The space 136 may be filled with adhesive layer 143. Due to the adhesive layer 143, the lens LS and the micro light emitting diode ED1 may be securely mounted on the array panel DPS with reliability.

The adhesive layer 143 may also be referred to herein as the fixation member.

For example, the fixation member may include photo acryl (PAC).

The adhesive layer 143 may further comprise light diffuser particles capable of diffusing light.

For example, the light diffuser particles may be, but are not limited to, inorganic light diffusers such as silica, alumina, glass, calcium carbonate (CaCO₃), talc, mica, barium sulfate (BaSO₄), zinc oxide (ZnO), cerium oxide (CeO₂), and titanium dioxide (TiO₂), or any mixture thereof.

The second planarization layer 151 may be disposed on the insulating layer 135 and the lens LS. The second planarization layer 151 may be made of a transparent organic material such as acryl-based resin or a poly(3,4-ethylenediox-ythiophene), PEDOT. The second planarization layer 151 may have a lower refractive index than the lens LS.

For example, the second planarization layer 151 may comprise an organic insulating material such as a polyacrylate resin, a polyimide resin, an epoxy resin, a phenolic resin, and a polyamide resin.

The second planarization layer 151 may also be referred to herein as an overcoat layer (OC).

Since the lens LS having the curved upper surface is disposed on each micro light emitting diode ED1, the light extraction efficiency of the micro light emitting diode ED1 may be improved. Accordingly, the display apparatus 100 may be operated with low power.

A protection film 155 may be disposed on the second planarization layer 151. An upper surface of the protection film 155 may be coated with at least one of an anti-reflection layer, an anti-glare layer and an anti-fingerprint layer.

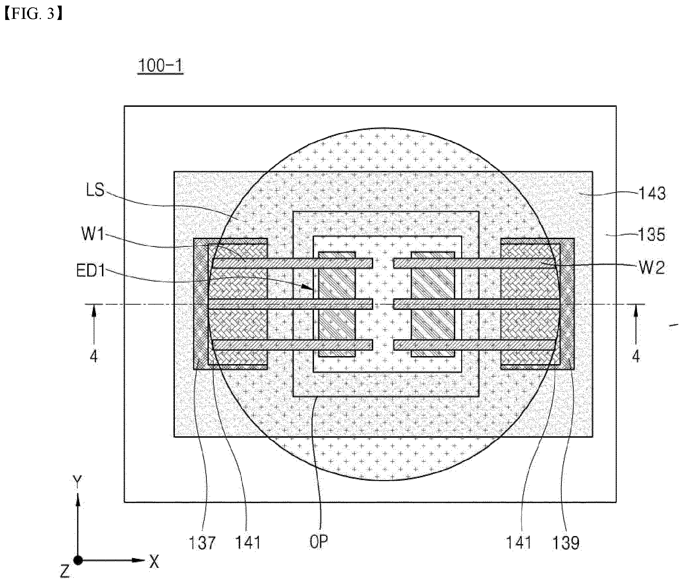

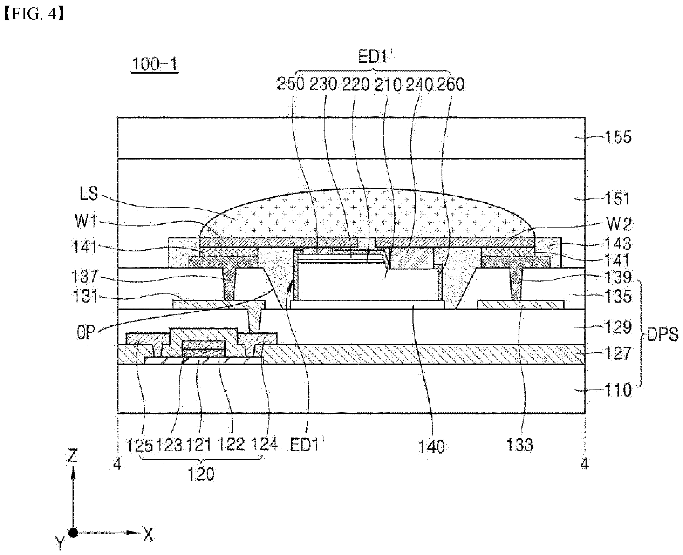

FIG. 3 is a plane view showing a display apparatus according to an embodiment of the present disclosure. FIG. 4 is a cross-sectional view cut along 4-4 of FIG. 3. FIGS. 3 and 4 show an area corresponding to one sub-pixel of the display apparatus 100-1.

Referring to FIGS. 3 and 4, the display apparatus 100-1 may include a first connection electrode 137 connected with a first electrode 131 through (e.g., a hole in) an insulating layer 135; and a second connection electrode 139 connected with a second electrode 133 through (e.g., another hole in) an insulating layer 135. A conductive adhesive layer 141 may be disposed on the first connection electrode 137 and the second connection electrode 139.

A micro light emitting diode ED1' may be mounted inside an opening OP of the insulating layer 135 in a horizontal chip arrangement in which an n-side electrode 240 and a p-side electrode 250 are arranged upwards. The micro light emitting diode ED1' may be disposed on a reflective layer 140 inside the opening OP. The reflective layer 140 may include metal with high visible light reflectivity such as aluminum (Al), silver (Ag), gold (Au), molybdenum (Mo) or magnesium (Mg).

A lens LS having first connection wires W1 and second connection wires W2 may be directly disposed on the micro light emitting diode ED1'. It is shown that three first connection wires W1 and three second connection wires W2 are disposed but it is one of examples, and another number of first connection wires W1 and another number of second connection wires W2 may be disposed. The first and second connection wires W1 and W2 may be made of a transparent conductive oxide such as indium tin oxide (ITO) or indium zinc oxide (IZO), a transparent conductive polymer such as poly(3-methylthiophene), poly(3,4-ethylenediox-ythiophene), PEDOT, polypyrrole and polyaniline, or the like or a metal such as silver (Ag), copper (Cu), etc. The first and second connection wires W1 and W2 may be formed by using conventional methods well known in the art to which the present disclosure pertains.

In the embodiment, at least a portion of a lower surface of the lens LS may be directly attached to the micro light emitting diode ED1' due to the adhesion force of the lens LS as would be understood. The micro light emitting diode ED1' and the lens LS may be simultaneously mounted on the array panel DPS by one transfer process.

Accordingly, unlike the conventional manufacturing method forming the lens by performing the photolithography process after the process of coating the material for forming the lens, this embodiment may not require the photolithography process for forming the lens, thereby simplifying the manufacturing method of the display apparatus 100-1 and reducing the manufacturing cost.

An adhesive layer 143 may be disposed between the lens LS and the insulating layer 135. The adhesive layer 143 may surround the first connection electrode 137, the second connection electrode 139 and the conductive adhesive layer 141. In addition, the adhesive layer 143 may be disposed inside the opening OP of the insulating layer 135 and may surround the micro light emitting diode ED1'. The micro light emitting diode ED1' may be securely and reliably mounted on the array panel DPS by the adhesive layer 143.

The first connection wires W1 may be connected with the first connection electrode 137 by the conductive adhesive layer 141. The second connection wires W2 may be connected with the second connection electrode 139 by the conductive adhesive layer 141.

The p-side electrode 250 of the micro light emitting diode ED1' may be connected with the first electrode 131 via the first connection wires W1, the conductive adhesive layer 141 and the first connection electrode 137. The first electrode 131 may be connected with a drain electrode 124 of a thin film transistor 120.

The n-side electrode 240 of the micro light emitting diode ED1' may be connected with the second electrode 133 via the second connection wires W2 and the second connection electrode 139. The second electrode 133 may be connected with low potential wires or ground wires (not shown).

Since the lens LS having a curved top surface is disposed on each micro light emitting diode ED1', light extraction efficiency of the micro light emitting diode ED1' may be improved. Accordingly, the display apparatus 100-1 may be operated with low power.

A second planarization layer 151 and a protection film 155 may be disposed on the lens LS.

In addition, the micro light emitting diode ED1' may include a passivation layer covering side surfaces of the n-type semiconductor layer 210.

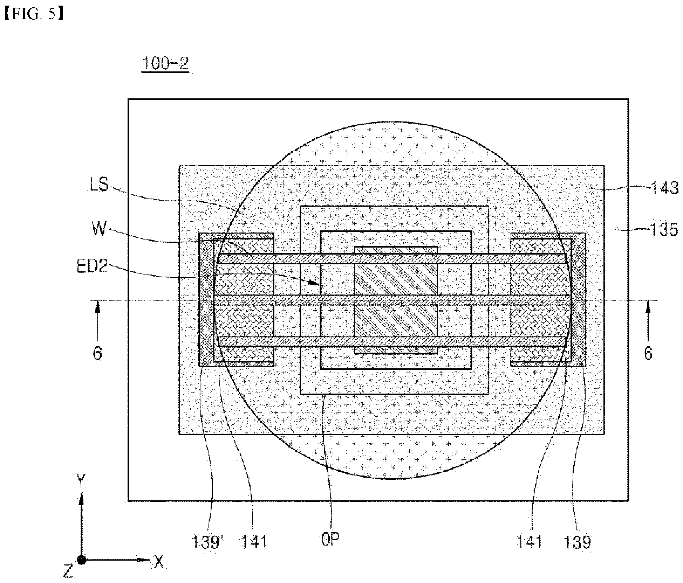

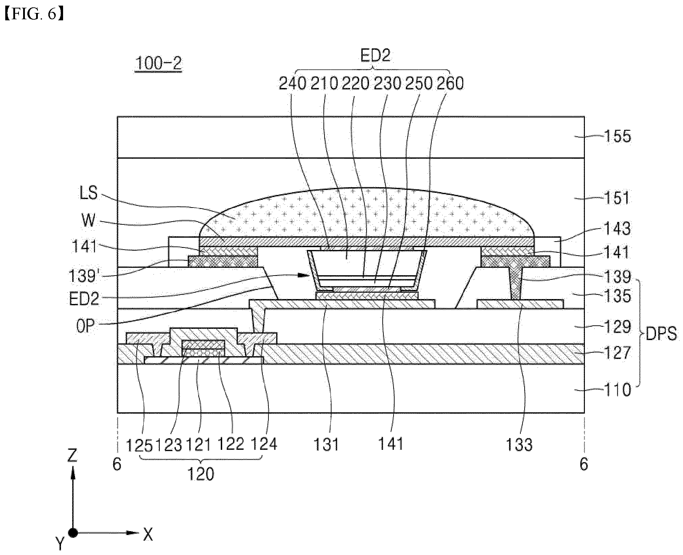

FIG. 5 is a plane view showing a display apparatus according to an embodiment of the present disclosure. FIG. 6 is a cross-sectional view cut along 6-6 of FIG. 5. FIGS. 5 and 6 show an area corresponding to one sub-pixel of the display apparatus 100-2.

Referring to FIGS. 5 and 6, the display apparatus 100-2 may include a first electrode 131 extending into an opening OP of an insulating layer 135 and a connection electrode 139 connected with a second electrode 133 through (e.g., a hole in) the insulating layer 135. The second electrode 133 may be at least partially covered by the insulating layer 135. A dummy connection electrode 139' may be disposed opposite to the connection electrode 139, spaced apart therefrom. In an embodiment, the dummy connection electrode 139' may be electrically connected with the connection electrode 139 through a connection wire described later. Since the dummy connection electrode 139' is disposed opposite to the connection electrode 139, a lens LS and a micro light emitting diode ED2 may be leveled. The micro light emitting diode ED2 may include an p-type semiconductor layer 230; an active layer 220 with a single quantum well SQW structure or a multi-quantum well MQW structure; a n-type semiconductor layer 210 disposed on the active layer 220; a p-side electrode 250 disposed on the first electrode 131; and an n-side electrode 240 disposed on the n-type semiconductor layer 210. In addition, the micro light emitting diode ED2 may include a passivation layer covering side surfaces of the n-type semiconductor layer 210 and p-type semiconductor layer 230.

A conductive adhesive layer 141 may be disposed on the second connection electrode 139 and the dummy connection electrode 139'. The conductive adhesive layer 141 may be disposed even on the first electrode 131.

Although not shown in FIG. 6, the micro light emitting diode ED2 may be disposed on a reflective layer within the opening OP. The reflective layer 140 may be disposed on top of the first planarization layer 129, but is not limited to, and may also be disposed below the first planarization layer 129.

The micro light emitting diode ED2 may be mounted in the opening OP of the insulating layer 135 in a vertical chip arrangement in which an n-side electrode 240 is disposed upward and a p-side electrode 250 is disposed downward. A lens LS in which connection wires W are formed may be directly disposed on the micro light emitting diode ED2. It is shown that three connection wires W are disposed but this is one example, and another number of connection wires W may be disposed. The connection wires W may be made of a transparent conductive oxide, a transparent conductive polymer, metal or the like. The connection wires W may be fabricated by using a conventional method well known in the art to which the present disclosure pertains.

In the embodiment, at least a portion of a lower surface of the lens LS may be directly attached to the micro light emitting diode ED2 due to the adhesion force of the lens LS as would be understood. Both the lens LS, on which the connection wires W are formed, and the micro light emitting diode DE2 may be mounted on the array panel DPS by one transfer process.

Accordingly, unlike the conventional manufacturing process of forming the lens by performing the photolithography process after the material for forming the lens is coated, the embodiment may not require the photolithography process for forming the lens, thereby simplifying the manufacturing method of the display apparatus 100-2 and reducing the manufacturing cost.

An adhesive layer 143 may be disposed between the lens LS and the insulating layer 135. The adhesive layer 143 may surround the connection electrode 139, the dummy connection electrode 139' and the conductive adhesive layer 141. It may be disposed even in the opening OP of the insulating layer 135 and surround the micro light emitting diode ED2. Due to the adhesive layer 143, the lens LS and the micro light emitting diode ED2 may be mounted on the array panel DPS with reliability.

The adhesive layer 143 may be a transparent adhesive layer comprising a transparent material.

For example, the adhesive layer 143 may include, but is not limited to, an Optically Clear Resin (OCR).

The connection wires W may be connected with the connection electrode 139 and the dummy connection electrode 139' by the conductive adhesive layer 141.

The p-side electrode 250 of the micro light emitting diode ED2 may be connected with the first electrode 131 by the conductive adhesive layer 141. The first electrode 131 may be connected with a drain electrode 124 of a thin film transistor 120.

The n-side electrode 240 of the micro light emitting diode ED2 may be connected with the second electrode 133 via the connection wires W and the connection electrode 139. The second electrode 133 may be connected with a low potential wire or ground wire (not shown).

Since the lens LS having a curved upper surface is disposed in each micro light emitting diode ED1, light extraction efficiency of the micro light emitting diode ED2 may be improved. Accordingly, the display apparatus 100-2 may be operated with low power.

A second planarization layer 151 and a protection film 155 may be disposed on the lens LS.

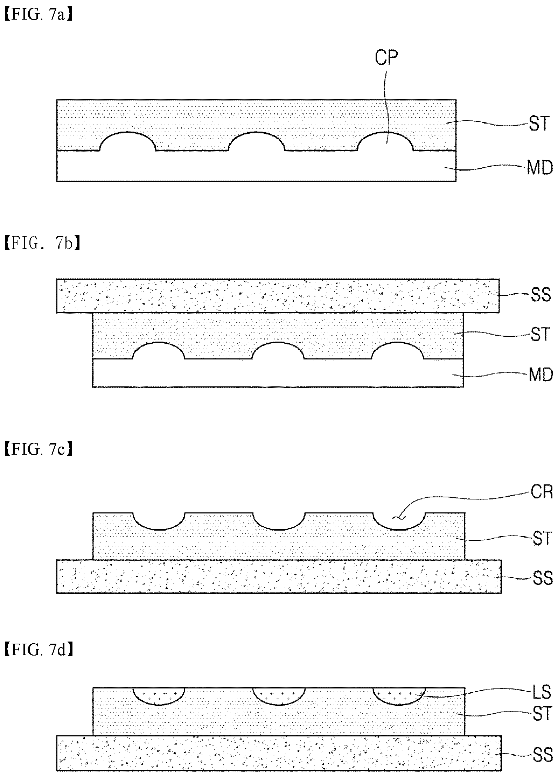

FIGS. 7a to 7f are views describing a manufacturing method of a display apparatus according to an embodiment of the present disclosure.

Referring to FIG. 7a, a mold MD including convex portions CP each having a convex curved surface may be manufactured. The convex portions CP may have a shape corresponding to the shape of the lens LS desired to be formed in a subsequential process. The mold MD may be manufactured by using a conventional method well known in the art to which the present disclosure pertains. A stamp ST is coated on the mold MD. For example, the stamp ST may be made of silicone rubber such as polydimethylsiloxane (PDMS) or elastomers such as polyurethane (PU) and polytetrafluoroethylene (PTFE).

Referring to FIG. 7b, a base substrate SS may be attached to the stamp ST. An adhesive layer may be further provided between the base substrate SS and the stamp ST. The adhesive layer may be made of a material well known in the art, specifically, a pressure-sensitive adhesive PSA, but the embodiment is not limited thereto, and may also be made of an optical clear adhesive (OCA), an optical clear resin (OCR), etc.

Referring to FIG. 7c, the mold MD is eliminated from the stamp ST. As a result, concave portions CR having a shape corresponding to the lens LS may be formed in the stamp ST.

Referring to FIG. 7d, lenses LS may be formed in the concave portions CR of the stamp ST. the lenses LS may be formed by coating an acryl-based resin or a poly(3,4-ethylenediox-ythiophene), PEDOT or the like on the concave portions CR.

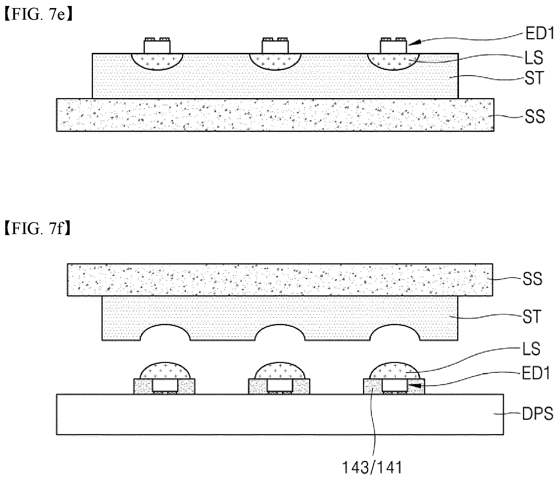

Referring to FIG. 7e, micro light emitting diodes ED1 may be primarily transferred to the lenses LS of the stamp ST.

The micro light emitting diodes ED1 may be lift-off by a laser lift-off process or a chemical lift-off process from a wafer on which the micro light emitting diodes ED1 are formed and disposed on a carrier substrate (or a donor substrate). The micro light emitting diodes ED1 may be primarily transferred to the lenses LS from the carrier (or the donor substrate) on which the micro light emitting diodes ED1 are disposed.

Referring to FIG. 7f, the micro light emitting diodes ED1 and the lenses LS may be secondarily transferred from the stamp ST to the array panel DPS.

After the adhesive layer 143 and the conductive adhesive layer 141 are coated on the array panel DPS, the stamp ST may be aligned and a proper transfer pressure may be applied. Then, the lens LS and the micro light emitting diodes ED1 may be simultaneously transferred to the array panel DPS.

To this end, the adhesion between the adhesive layer 143 and the lens LS may be designed to be greater than the adhesion between the lens LS and the stamp ST. the adhesion between the micro light emitting diode ED1 and the lens LS may be designed to be greater than the adhesion between the lens LS and the stamp ST.

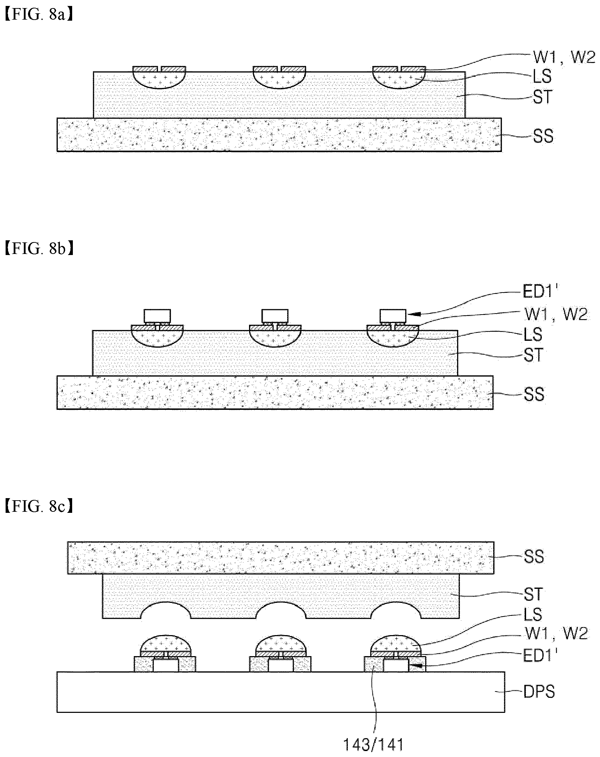

FIGS. 8a to 8c are views describing a manufacturing method of a display apparatus 100-1 according to an embodiment of the present disclosure.

Referring to FIG. 8a, the lenses LS may be formed in the concave portions CR of the stamp ST as described above referring to FIGS. 7a to 7d. After that, the connection wires W1 and W2 may be formed on the lenses LS. The connection wires W1 and W2 may be made of a transparent conductive oxide, a transparent polymer, a metal or the like. The connection wires W1 and W2 may be formed by using a well-known method of the art to which the present disclosure pertains.

Referring to FIG. 8b, the micro light emitting diodes ED 1' may be primarily transferred to the lenses LS of the stamp ST. The micro light emitting diodes ED1' may be primarily transferred to the lenses LS from the wafer, in which the micro light emitting diodes ED1' is formed, by the laser lift-off process or the chemical lift-off process.

Referring to FIG. 8c, the micro light emitting diodes ED1', the connection wires W and the lenses LS may be secondarily transferred from the stamp ST to the array panel DPS.

After the adhesive layer 143 and the conductive adhesive layer 141 are coated on the array panel DPS, the stamp ST may be aligned and an appropriate transfer pressure may be applied. Accordingly, the lens LS, the micro light emitting diodes ED1' and the connection wires W1 and W2 may be simultaneously transferred to the array panel DPS.

To this end, the adhesion between the lens LS and the stamp ST may be designed to be smaller than the adhesion between the adhesive layer 143 and the lens LS. Also, the adhesion between the micro light emitting diode ED1' and the lens LS may be designed to be greater than the adhesion between the lens LS and the stamp ST.

The display apparatus and the manufacturing method of the same according to the embodiments of the present disclosure are described as follows.

The display apparatus according to the embodiments of the present disclosure may include a substrate: a planarization layer disposed on the substrate: a first electrode and a second electrode that are disposed on the planarization layer; an insulating layer disposed on the first electrode and the second electrode, the insulating layer comprising an opening: a micro light emitting diode disposed inside the opening of the insulating layer; a lens disposed on the micro light emitting diode; and an adhesive layer disposed between the lens and the insulating layer.

According to some embodiments of the present disclosure, the adhesive layer surrounds side surfaces of the micro light emitting diode inside the opening.

According to some embodiments of the present disclosure, the first electrode and the second electrode may be exposed by the opening, and the micro light emitting diode may be mounted in the first electrode and the second electrode in a flip-chip type in which a n-side electrode and a p-side electrode are disposed downward.

According to some embodiments of the present disclosure, the display apparatus may further include a first connection electrode connected to the first electrode through the insulating layer; a second connection electrode connected with the second electrode through the insulating layer; and first connection wires and second connection wires disposed on a lower surface of the lens.

According to some embodiments of the present disclosure, the micro light emitting diode may be disposed inside the opening in a horizontal chip type in which an n-side electrode and a p-side electrode are disposed upward. The p-side electrode of the micro light emitting diode may be connected with the first electrode via the first connection wires and the first connection electrode, and the n-side electrode of the micro light emitting diode is connected to the second electrode via the second connection wires and the second connection electrode.

According to some embodiments of the present disclosure, the display apparatus may further include a connection electrode connected with the second electrode through the insulating layer; a dummy connection electrode disposed on the insulating layer; and connection wires disposed on a lower surface of the lens.

According to some embodiments of the present disclosure, the first electrode may be exposed by the opening. The micro light emitting diode may be disposed inside the opening in a vertical chip arrangement in which an n-side electrode is disposed upward and a p-side electrode is disposed downward. The p-side electrode of the micro light emitting diode may be connected with the first electrode, and the n-side electrode of the micro light emitting diode may be connected with the second electrode via the connection wires and the connection electrode.

A manufacturing method of a display apparatus according to the embodiments of the present disclosure may include forming a stamp having concave portions; forming lenses in the concave portions; primarily transferring micro light emitting diodes to the lenses; preparing an array substrate on which an adhesive layer is coated on each sub-pixel; and secondarily transferring the lenses and the micro light emitting diodes together to the array substrate.

According to some embodiments of the present disclosure, the manufacturing method of the display apparatus may further include forming connection wires on the lenses, after the forming the lenses in the concave portions.

According to some embodiments of the present disclosure, the connection wires may include at least one first connection wire and at least one second connection wire, which are spaced apart from each other.

According to some embodiments of the present disclosure, the stamp may be made of polymethylsiloxane and the lenses may be made of acryl-based resin.

According to some embodiments of the present disclosure, adhesion between the adhesive layer and the lenses may be greater than adhesion between the lenses and the stamp.

The display apparatus according to the embodiments of the present disclosure may include a substrate: a first electrode and a second electrode that are disposed on the substrate; a bank layer disposed on the first electrode and the second electrode, the bank layer comprising an opening; a micro light emitting diode disposed inside the opening of the bank layer; a high refractive index layer disposed on the micro light emitting diode; an overcoat layer disposed on the high refractive index layer and having a lower refractive index than the high refractive index layer; and an adhesive layer disposed between the lens and the insulating layer.

According to some embodiments of the present disclosure, the fixation member surrounds side surfaces of the micro light emitting diode inside the opening.

According to some embodiments of the present disclosure, the first electrode and the second electrode may be exposed by the opening, and the micro light emitting diode may be mounted in the first electrode and the second electrode in a flip-chip arrangement in which an n-side electrode and a p-side electrode are disposed downward.

According to some embodiments of the present disclosure, the display apparatus may further include a first connection electrode connected to the first electrode through the bank layer; a second connection electrode connected with the second electrode through the bank layer; and first connection wires and second connection wires disposed on a lower surface of the high refractive index layer.

According to some embodiments of the present disclosure, the micro light emitting diode may be disposed inside the opening in a horizontal chip arrangement in which a n-side electrode and a p-side electrode are disposed upward, the p-side electrode of the micro light emitting diode may be connected with the first electrode via the first connection wires and the first connection electrode, and the n-side electrode of the micro light emitting diode may be connected to the second electrode via the second connection wires and the second connection electrode.

The display apparatus according to the embodiments of the present disclosure may include a substrate; a first electrode and a second electrode disposed on the substrate; a bank layer disposed on the first electrode and the second electrode to define pixels; a micro light emitting diode disposed within each of the pixels; and a connection electrode penetrating the bank layer and connected to the second electrode, wherein the micro light emitting diode comprises a lower portion electrically connected to the first electrode and an upper portion electrically connected to the second electrode via the connection electrode.

According to some embodiments of the present disclosure, the micro light emitting diode may be in the form of a vertical chip.

According to some embodiments of the present disclosure, the upper portion may be electrically connected to the connection electrode via connection wires.

According to some embodiments of the present disclosure, the micro light emitting diode may be disposed on a reflective layer in an opening of the bank layer.

According to some embodiments of the present disclosure, the micro light emitting diode may comprise an n-side electrode disposed upward and a p-side electrode disposed downward.

According to some embodiments of the present disclosure, the micro light emitting diode may further include an n-type semiconductor layer and a p-type semiconductor layer.

According to some embodiments of the present disclosure, the micro light emitting diode may include a passivation layer covering side surfaces of the n-type semiconductor layer and p-type semiconductor layer.

According to some embodiments of the present disclosure, the micro light emitting diode may further include an active layer with a single quantum well SQW structure or a multi-quantum well MQW structure; the n-type semiconductor layer disposed on the active layer; the p-side electrode disposed on the first electrode; and the n-side electrode disposed on the n-type semiconductor layer.

According to some embodiments of the present disclosure, the display apparatus may further comprise a high refractive index layer disposed on the micro light emitting diode.

According to some embodiments of the present disclosure, the display apparatus may further comprise an overcoat layer disposed on the high refractive index layer, the overcoat layer having a lower refractive index than the high refractive index layer.

According to some embodiments of the present disclosure, the display apparatus may further comprise a fixation member disposed between the high refractive index layer and the bank layer.

According to some embodiments of the present disclosure, the high refractive index layer may comprise a lens.

The display apparatus according to the embodiments of the present disclosure may include a substrate: a first electrode and a second electrode that are disposed on the substrate; a bank layer disposed on the first electrode and the second electrode, the bank layer comprising an opening; a micro light emitting diode disposed inside the opening of the bank layer; a high refractive index layer disposed on the micro light emitting diode; an overcoat layer disposed on the high refractive index layer and having a lower refractive index than the high refractive index layer; and a fixation member disposed between the high refractive index layer and the bank layer.

Although the present disclosure has been described with reference to the exemplified drawings, it is to be understood that the present disclosure is not limited to the embodiments and drawings disclosed in this specification, and those skilled in the art will appreciate that various modifications are possible without departing from the scope of the present disclosure. Further, although the operating effects according to the configuration of the present disclosure are not explicitly described while describing an embodiment of the present disclosure, it should be appreciated that predictable effects are also to be recognized by the configuration.

## Claims

1. A display apparatus comprising:
a substrate (110):
a first electrode (131) and a second electrode (133) that are disposed on the substrate;
a bank layer (135) disposed on the first electrode and the second electrode, the bank layer comprising an opening (OP);
a micro light emitting diode (ED2) disposed inside the opening of the bank layer;
a high refractive index layer (LS) disposed on the micro light emitting diode;
an overcoat layer (151) disposed on the high refractive index layer and having a lower refractive index than the high refractive index layer; and
a fixation member (143) disposed between the high refractive index layer and the bank layer.

2. The display apparatus of claim 1, further comprising:
a connection electrode (139) connected with the second electrode (133) through the bank layer (135).

3. The display apparatus of claim 2 further comprising a dummy connection electrode (139') disposed on the bank layer (135).

4. The display apparatus of claim 3 further comprising
connection wires (W) disposed on a lower surface of the high refractive index layer (LS).

5. The display apparatus of any preceding claim, wherein the first electrode (131) is exposed by the bank opening (OC).

6. The display apparatus of any preceding claim wherein the micro light emitting diode (ED2) is disposed inside the bank opening (OC) in a vertical chip arrangement in which an n-side electrode (240) is disposed upward and a p-side electrode (250) is disposed downward

7. The display apparatus of claim 6 wherein the p-side electrode (250) of the micro light emitting diode (ED2) is connected with the first electrode (131).

8. The display apparatus of claim 7 wherein the n-side electrode (240) of the micro light emitting diode (ED2) is connected with the second electrode (133) via the connection wires (W) and the connection electrode (39').

9. The display apparatus of any preceding claim wherein a protection film (155) is disposed on the overcoat layer (151).

10. The display apparatus of any preceding claim wherein the fixation member (143) surrounds the connection wires (W).

11. The display apparatus of any preceding claim wherein the first electrode (131) is connected to a driving chip.

12. The display apparatus of any preceding claim wherein the bank layer (135) comprises black pigment.

13. The display apparatus of any of claims 9 to 12 wherein an upper surface of the protection film (155) is coated with at least one of an anti-reflection layer, an anti-glare layer or an anti-fingerprint layer.

## Amended claims

### Amended claims in accordance with Rule 137(2) EPC.

1. A display apparatus comprising:
a substrate (110):
a first electrode (131) and a second electrode (133) that are disposed on the substrate;
a bank layer (135) disposed on the first electrode and the second electrode, the bank layer comprising an opening (OP);
a micro light emitting diode (ED2) disposed inside the opening of the bank layer;
a high refractive index layer (LS) disposed on the micro light emitting diode;
an overcoat layer (151) disposed on the high refractive index layer and having a lower refractive index than the high refractive index layer; and
a fixation member (143) disposed between the high refractive index layer and the bank layer.

2. The display apparatus of claim 1, further comprising:
a connection electrode (139) connected with the second electrode (133) through the bank layer (135).

3. The display apparatus of claim 2 further comprising a dummy connection electrode (139') disposed on the bank layer (135).

4. The display apparatus of claim 3 further comprising
connection wires (W) disposed on a lower surface of the high refractive index layer (LS).

5. The display apparatus of any preceding claim, wherein the first electrode (131) is exposed by the bank opening (OC).

6. The display apparatus of any preceding claim wherein the micro light emitting diode (ED2) is disposed inside the bank opening (OC) in a vertical chip arrangement in which an n-side electrode (240) is disposed upward and a p-side electrode (250) is disposed downward

7. The display apparatus of claim 6 wherein the p-side electrode (250) of the micro light emitting diode (ED2) is connected with the first electrode (131).

8. The display apparatus of claim 7 when in combination with claim 4 and claim 2, wherein the n-side electrode (240) of the micro light emitting diode (ED2) is connected with the second electrode (133) via the connection wires (W) and the connection electrode (139).

9. The display apparatus of any preceding claim wherein a protection film (155) is disposed on the overcoat layer (151).

10. The display apparatus of any preceding claim wherein the fixation member (143) surrounds the connection wires (W).

11. The display apparatus of any preceding claim wherein the first electrode (131) is connected to a driving chip.

12. The display apparatus of any preceding claim wherein the bank layer (135) comprises black pigment.

13. The display apparatus of any of claims 9 to 12 wherein an upper surface of the protection film (155) is coated with at least one of an anti-reflection layer, an anti-glare layer or an anti-fingerprint layer.
